Europäisches Patentamt

European Patent Office

Office européen des brevets

(19)

(11) **EP 1 198 038 A2**

(12) **EUROPEAN PATENT APPLICATION**

(43) Date of publication:
**17.04.2002 Bulletin 2002/16**

(51) Int Cl.[7]: **H01S 3/08**, H01S 5/10

(21) Application number: **01123380.6**

(22) Date of filing: **10.10.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **10.10.2000 KR 2000059431**

(71) Applicant: **Korea Advanced Institute of Science and Technology**
**Taejon 305-701 (KR)**

(72) Inventors:
• **An, Kyung-Won,**
**Korea Advanced Inst. of Sc. and Tec**
**Yusong-gu, Taejon 305-701 (KR)**

• **Moon, Hee-Jong**
**Korea Advanced Inst. of Sc. and Tec**
**Yusong-gu, Taejon 305-701 (KR)**
• **Chough, Young-Tak**
**Korea Adv. Inst. of Sc. and Tec**
**Yusong-gu, Taejon 305-701 (KR)**

(74) Representative:
**Reinhard - Skuhra - Weise & Partner**
**Friedrichstrasse 31**
**80801 München (DE)**

(54) **Evanescent-wave coupled microcavity laser**

(57) Disclosed is an evanescent-wave-coupled microcavity laser in which a gain medium (120) is positioned outside a circularly symmetric microcavity (110) having a size of a few tens of microns to a few hundreds of microns to generate a laser oscillation using a gain medium existing in the evanescent-field of a resonance mode. Particularly, a gain medium containing a semiconductor, atoms, molecules, or quantum dots is placed outside the microcavity where the evanescent-wave of the microcavity mode exists, to be excited by an electric or an optical pumping. Fluorescence irradiated from the excited gain medium is coupled with the evanescent-wave of the resonator mode to obtain a gain, so that amplification of light is triggered. The amplified light circulates inside the microcavity through total internal reflection to induce a stimulated emission of radiation from the excited gain medium in the field of evanescent-wave so that a stable laser oscillation is established. Particularly, the present invention includes the evanescent-wave-coupled microcavity lasers using the microspheres of extremely low energy loss, microdisks or microcylinders capable of being large-scale integrated.

FIG. 1

EP 1 198 038 A2

**Description**

BACKGROUND OF THE INVENTION

Field of the Invention

The present invention relates to a microcavity laser based on the evanescent-wave coupled gain.

Description of the Related Art

The evanescent wave is the electromagnetic field generated when light undergoes total internal reflection at an interface of two contiguous media, the intensity of which decays exponentially along the distance from the interface. The total internal reflection occurs when light is incident at an angle greater than an angle known as the "critical angle" from inside the medium of lower refractive index towards the other side of higher index. Evanescent wave is thus generated at any such interface as the boundary surface of a planar waveguide (the interface with air), the core-clad interface of an optical fiber, or the surface of a microsphere cavity (interface with air), etc.

The existence of evanescent wave can be easily demonstrated by placing a sharp tip of a metal piece near to (but physically detached from) the wider surface of a right-angle prism under which the light is being totally internal-reflected. Then the light inside the prism tunnels through the gap and hit the metal tip making it shining bright, which may be interpreted as one of the exotic quantum effects. Also, in a recent experiment, an optical fiber tip is placed near the surface of a spherical microcavity, and the coupling of light through the optical fiber was observed.

The evanescent field is indeed widely being used in various techno-academic fields, the examples which extend to the study on the surface adsorption process using the cavity ring-down spectroscopy, the experiments on capturing atoms on the surface of a prism, or the Q-switching operations making use of the absorbent property of liquid on a prism which is placed inside a laser resonator at the critical angle (of the total internal reflection), etc.

On the other hand, the resonance modes in a cylindrical, disk-like, or spherical cavity having higher refractive index than that of the surrounding medium are the so called whispering gallery modes (WGM's) which are defined by mode number "$n$" and mode order "$l$." To be specific, there are indeed two different types of WGM's, namely, the TM-mode (Transverse Magnetic mode) and TE-mode (Transverse Electric mode) according to the polarization state of light in the WGM. It is well known that the WGM's in those circular microcavities in general have very large values of resonance quality factor (Q), and high-Q implies a well-defined frequency of light, most importantly. For this reason, much attention is being paid to these microcavities in the community of laser science and technology, in the interest of taking advantage of such high-Q values of WGM's thereof.

A number of experiments have been performed on laser oscillation in the microcavities such as solid microspheres, liquid droplets, and liquid jets, etc., based upon the excitations of the WGM's in the cavities. The WGM lasers and polymer disk lasers in semiconductor microdisk structures are being actively studied for the purpose of practical implementation. Particularly, such semiconductor microdisk lasers are expected to be in an explosive demand, in the very near future, in the fields of information processing such as optical computers and optical communications, etc, for the advantage of extremely low power consumption and the possibility of large-scale integration.

However, in the general scheme of these experiments, the gain medium (dye) is placed inside the resonator. which is simply the conventional laser configuration. The problem is that these conventional microcavity lasers in common have a serious drawback due to the very fact of the gain medium existence within the resonator. That is, because the gain medium is inside the resonator, the Q value is inevitably degraded due to the unavoidable thermal effects coming into play when the gain medium is heated up. One may simple-mindedly consider putting the gain medium outside the resonator to avoid the heating problem, but then the question is how to achieve the coupling between the mode *inside* the resonator and the gain medium *outside.* The inventors realized that the coupling could be achieved through the evanescent field as the mode inside is stretched through the evanescent field to the exterior region where the gain medium exists.

Indeed, already in 1970's, it was demonstrated that light can be amplified by such evanescent-wave-coupled gain in a planar waveguide, and recently, the observation of laser excitation in an optical fiber in which the gain medium is doped in the fiber cladding was reported. These optical fiber lasers are being the focus of attention as the potential optical amplifiers or light sources in the field of optical communications. However, one of the concerns with these systems is that the Q values are not desirably large due to the character of the resonator configurations. This is why these are not really considered as an achievement of ultra-high Q laser systems.

The microcavities such as liquid droplets or liquid jets, on the other hand, can have relatively high-Q modes as they can sustain the high-Q WGM's in them, as aforementioned. However, one of the problems with these microcavities is that they are quite sensitive to thermal perturbations and therefore can have only limited Q values which cannot be expected to be any greater than $10^8$. The solid microspheres, made of fused silica for instance, however, can have the effective Q values of nearly $10^{10}$. Thus the development of a laser based upon the excitation of the high-Q modes in such a solid microsphere with the evanescent-wave-coupled gain which will not affect the Q values will be an authentic breakthrough in the technology of high-Q lasers and will have vast industrial. Yet, the research and development (R&D) on such novel types of laser systems has just begun.

In summary, although the optical amplification and optical fiber laser oscillation based upon the evanescent-wave-coupling have been achieved, these concepts and technologies have never been extended to the ultra-high-Q microcavities, not to mention any inventions of such microcavity lasers based on the evanescent wave-coupled gain. Furthermore, since the conventional microcavity lasers have the gain media within the resonators, they can have only limited Q values due to the thermal effect of the heated gain media. It is the inventors who actually realized for the first time on record such an ultra-high-Q microcavity lasers based upon the evanescent-wave-coupled-gain in an entirely different concept from the conventional laser schemes.

SUMMARY OF THE INVENTION

As aforementioned, the inventors developed an ultra-high-Q microcavity lasers based upon the evanescent-wave-coupled-gain by placing the laser gain medium outside an ultra-high-Q microcavity resonator, thereby minimizing the influence of the thermal effects on the resonance Q value. To summarize the primary advantages of the invention, the invention is a microcavity laser (1) which has an unprecedentedly high-Q value ranging from $10^9$ to $10^{10}$, (2) which can have an ultra-low threshold owing to the ultra-high-Q, (3) the frequency of which is tunable, (4) the single mode operation of which is possible, where the frequency tuning is achieved by controlling the doping concentration of the gain medium and surface finesse (smoothness) of the microcavity, (5) which has the possibility of a large-scale integration as the size of the microcavities can be as small as a few tens of microns, and (6) which can be an entirely new light source of quantum-field when the fundamental quantum-mechanical objects such as a single atom, single molecule, or a quantum dot are used as the gain medium.

The invention comprises

a microcavity having a circularly symmetric structure,
a gain medium, having a refractive index lower than that of the microcavity, disposed outside the microcavity, and
a mechanism of energy input to excite the gain medium and trigger the laser oscillation.

BRIEF DESCRIPTION OF THE DRAWINGS

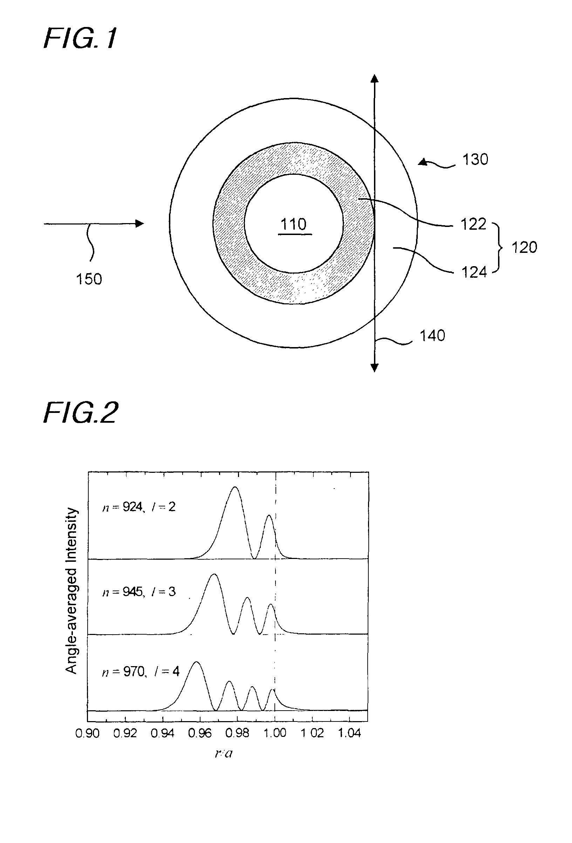

Note that the invention can be embodied in a variety of different ways. Particularly the geometry of the microcavity can be anything as long as it can sustain the whispering gallery mode in it. Figures 1 - 4 are regarding the case of a cylindrical microcavity adopted in the prototypal embodiment of the invention, while the rest of the figures are for other possible configurations.

FIG. 1 is a schematic diagram of the geometrical structure of the prototypal embodiment of the invention with a cylindrical microcavity, viewed into the direction of the cavity axis.

FIG. 2 is a plot showing the spatial distributions of WGM's, including the evanescent-field tales, in a cylindrical microcavity used in the prototypal embodiment.

FIG. 3 is a sketch of a cylindrical microcavity laser with the evanescent-wave coupling.

FIG. 4 is a plot showing the spectral profiles of the WGM's excited to laser oscillation via the evanescent-wave-coupled gain.

FIG. 5 is a sketch of an evanescent-wave coupled spherical microcavity laser, which is one of the desirable configurations of the invention.

FIG. 6 is a sketch of an evanescent-wave-coupled disc-shaped microcavity, which is one of the desirable configurations of the invention.

FIG. 7 is a sketch of a desirable configuration of a quantum-field microcavity laser in which a quantum mechanical object such as a single quantum dot, atom or molecule is placed in the evanescent-wave region of a high-Q microsphere.

DETAILED DESCRIPTION OF THE PREFERRED EMBODIMENTS

FIG. 1 schematically depicts the structure of the prototypal embodiment of the invention using a cylindrical microcavity. It shows the circular microcavity (110), the gain medium (120), the exterior region (130), the laser output (140) from the laser oscillation of WGM, and external pump (150). The circular microcavity (110) is a cylinder with a circular cross-section the size of which ranges from a few tens to a few hundreds of microns in diameter, a smooth surface. The circular shape of the microcavity is indispensable for the high-Q WGM excitations inside. Indeed, the circular microcavity (110) can be a cylinder, a disk, a sphere, or an ellipsoid, etc. The gain medium (120) should have a refractive index lower than that of the medium that the circular microcavity (110) is made of, and it is the region where the gain material such as the fluorescent molecules, atoms, quantum dots or semiconductor p-n junctions are distributed. The laser gain is generated in the effective gain region (122) where the evanescent-wave of the WGM exists. The region (124) merely indicates the rest of the volume in the gain medium (120) in which the evanescent-wave vanishes. The effective gain region (122) has a thickness on the order of the wavelength of light in the laser field. The exterior region (130) should have a refractive index higher than that of the gain medium (120) so that WGM's do not exist at the interface of (130) and (120). Also the ratio of the refractive indices must satisfy the conditions for the high-Q WGM's to be sustained within (110). The laser output (140) is in fact the leakage of the WGM's circulating within the boundary of the microcavity (110) via the total internal reflection. Thus the laser output (140) is coupled out to the free space in tangential directions from every point on the cavity boundary interface. In order for the gain medium (120) to be excited, energy should be pumped in from outside. When the gain medium comprises the fluorescent atoms or molecules, the pumping will be done by an external irradiation of light energy. If the gain medium contains quantum dots, the pumping mechanism can be either a light irradiation or an electric voltage supply. When the gain medium contains the semiconductor *p-n* junctions or quantum wells, an electric current will pump it. Since the microcavities with ultra-high-Q values can have very low threshold energy, these offer an important advantage that the fabrication of the microcavity lasers of extremely low power consumption is possible.

FIG. 2 is a plot showing some typical spatial distributions of the WGM's along the radial distance (*r*) from the axis of the cavity, including the evanescent-wave tails thereof, in a cylindrical microcavity of radius (*a*) 62.5 microns. Here the cylindrical microcavity is none other than a piece of optical fiber having refractive index 1.455 and diameter 125 microns. It is shown that the WGM of mode order *l* has *l* intensity peaks, with the evanescent-wave tails exponentially decaying, along the radial direction. Let η denote the ratio of the volume occupied by the evanescent-wave region and the volume of the WGM. Obviously η is very small and in fact ranges approximately from 1/15 to 1/30. The fact that η is much smaller than unity implies that most of the light in the lasing mode is confined within the cavity, and thereby the influence of the field in the evanescent-wave region to the gain medium is minimized. The frequency of the WGM in lasing operation is determined by the point that minimizes the function γ(λ) such that

$$\gamma(\lambda) = \frac{2\pi m/(\lambda n_t \eta Q) + \sigma_a(\lambda)}{\sigma_e(\lambda) + \sigma_a(\lambda)} - \qquad \text{Equation 1,}$$

where λ denotes the wavelength, $\sigma_a(\lambda)$ the absorption cross-section of the gain medium at λ, $\sigma_e(\lambda)$ the emission cross-section of the gain medium at λ, $n_t$ the number of molecules, atoms or quantum dots per unit volume in the gain medium, and *m* the relative refractive index of the microcavity to the gain medium. Thus either by changing the Q value of the medium concentration $n_t$, the lasing frequency can be shifted and thereby frequency tuning is achieved.

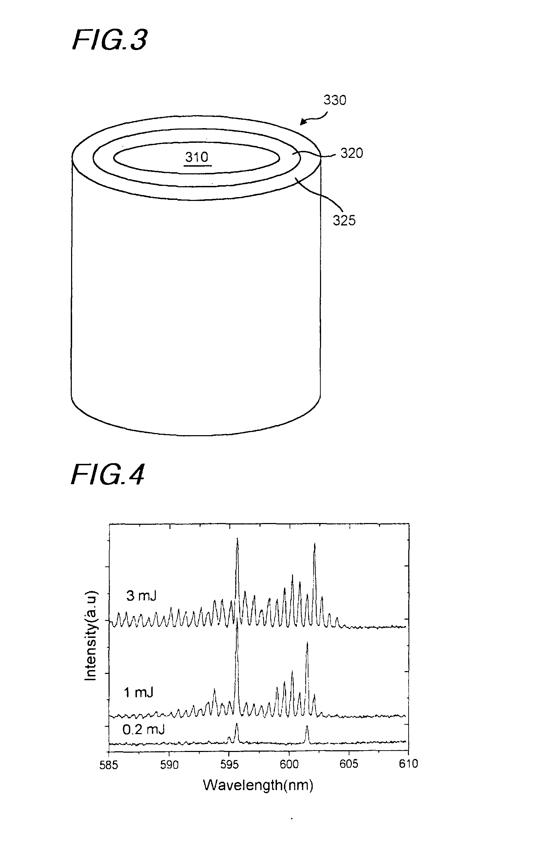

FIG. 3 is a sketch of a prototypal embodiment of the invention using cylindrical microcavity. A cylindrical microcavity (310) is submerged in the gain medium (320) which has a refractive index lower than that of the cavity (310) inside. The gain medium (320) is again surrounded by a protective layer (325) which has a refractive index higher than that of the gain medium (320). The rest is the external region (330). If (330) has a greater refractive index than that of (325), there is no limitation on the thickness of (325). However, if (330) has a smaller refractive index than that of (325), the layer (325) needs to be sufficiently thick in order to keep the WGM's possibly excited along the interface of (324) and (330) from touching the region of the gain medium (320), since otherwise such WGM's may also lase and interfere. Particularly, the thickness should not be less than *b*(1-1/*m*') if the relative refractive index of (325) to (330) is *m*' and *b* is a radius of the layer (325). In this embodiment, a piece of single mode optical fiber, 125 microns in diameter, was used as the cylindrical microcavity (310), and the ethanol-base rhodamine 6G solution of concentration 2mM/L was used as the gain medium (320). The external protective layer (325) is made of a fused silica capillary that has a refractive index of 1.458. Since the refractive index of the ethanol is 1.361, smaller than the refractive index, 1.455, of the optical fiber, the high-Q WGM's exist at the interface between the ethanol and the optical fiber. A Q-switched Nd: YAG laser pulse of width 10 ns and wavelength 532 nm was used as the pumping light source.

FIG. 4 shows the spectral profiles of the WGM's excited in a cylindrical microcavity. This figure evidences that the generated signal is the output from the WGM's in the optical fiber in laser operation. For the pumping light intensity 0.2mJ, only three peaks are shown on the spectrum, but as the intensity of the pumping light increases to 1mJ and 3mJ, etc., the number of the peaks also increases. This indicates that the generated signal light has a threshold characteristic as the typical multi-mode laser. The interval between the peaks is measured to be approximately 0.6nm, which is consistent with the mode spacing calculated for the cylindrical microcavity of diameter 125 microns. It therefore confirms that the measured spectrum is that of the light coupled out of the WGM's inside the microcavity via the evanescent-wave. From Equation 1, it can be shown that the mode observed around the wavelength 600nm is a WGM oscillation with the Q-value of approximately $3 \times 10^7$. In the figure, it is also seen that for a sufficiently weak pump intensity, essentially a single mode is excited. It turned out that single mode operations are possible even for stronger pump intensities for some other types of optical fibers. Such single frequency oscillations have a direct relationship with the surface finesse of the optical fiber. Such microcavity lasers capable of single operation by controlling the surface roughness will have vast applications. The capability of the single mode operation is important particularly because the light sources used in the optical communications mostly require this capability. In the present invention, the single mode capability is accomplished by periodically fabricated surface roughness in much the same structure as a grating. That is, when the mode number of the WGM to be excited is $n$, the surface roughness of approximately a few tens of nanometers is periodically fabricated $2n$ times around on the microcavity surface. Then the modulation of the Q value is generated due to constructive and destructive interference effects of the WGM's, and only the WGM with mode number $n$ can be constructively interfered to become the only surviving mode. This is how the single mode operation is achieved in the present invention, which know-how itself is an invention proposed by the present inventors.

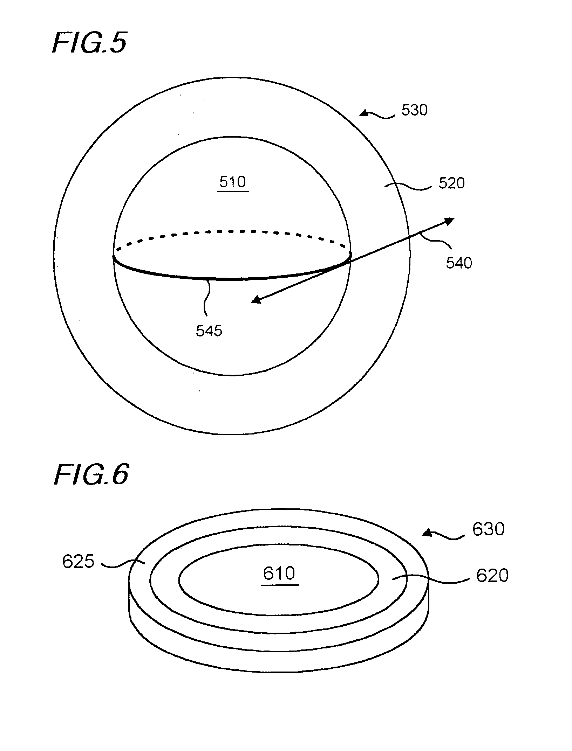

FIG. 5 is a sketch of an evanescent-wave coupled spherical microcavity laser, where an ultra-high-Q spherical microcavity is used. A spherical microcavity (510) of which size may range from a few tens microns to a few hundreds microns is enclosed with a gain medium (520) having a lower refractive index than that of the cavity. The WGM (545) 's generated at the interface of (510) and (520) is to be used for a laser oscillation. As in the case of the cylindrical microcavity, the external region (530) is made to have a refractive index greater than (520) or otherwise the interface between (530) and (520) is made to have a high roughness. The laser output (540) from the excited WGM's is coupled out into the tangential directions from every point in the pumped region on the cavity surface. In case of the spherical microcavity, the WGM excitations are possible in any circular orbits of radius $a$ (the great circles) due to the spherical symmetry that the laser output is irradiated isotropically. This problem can be simply fixed, either by distributing the gain medium (520) only on the desired region on the cavity surface, or by slightly compressing the spherical cavity so that it is distorted into an ellipsoidal shape. Then the WGM oscillations can occur along the great circles only in the designated region on the cavity surface. In case of electric current pumping, two electrodes are to be placed at the north and south poles while the WGM excitations are arranged to occur along the equator.

FIG. 6 is a sketch of the embodiment of the invention using a disc-shape microcavity. In case of the semiconductor quantum well microcavities of AlGaAs or InGaP, etc., the microcavity itself functions as the gain medium. In the present invention, however, such semiconductor gain substance is to be disposed outside an ultra-high-Q disk-shape microcavity. In the semiconductor structures in general the refractive index changes as the doping concentration is varied. In the embodiment of FIG. 6, the disk-type microcavity (610) and the gain medium (620) are fabricated to have different doping concentrations so that (610) has a refractive index higher than (620). Similarly the doping concentration of the external region (630) is controlled so that the refractive index of (630) is higher than that of (620). Under such configuration, the WGM's at the interface of (610) and (620) can be excited by an electric or an optical pumping from an outside. The protective layer (625) may be the same as the external region (630). Otherwise, if the refractive index of (630) is smaller than (625), the possible WGM excitations at the interface between (625) and (630) should be suppressed by the methods sufficiently described previously.

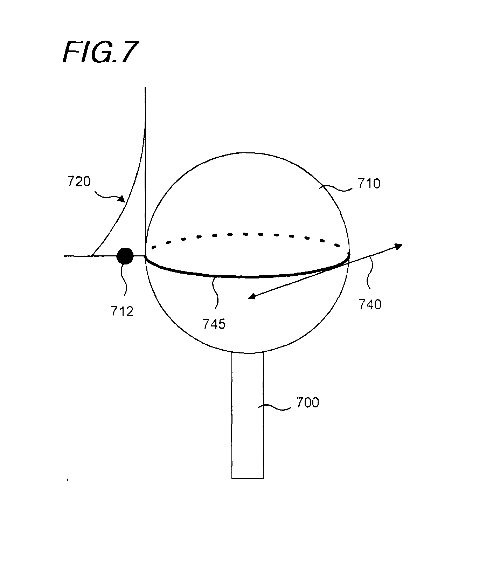

FIG. 7 is a sketch of a quantum-field laser, which will serve as light source of an entirely new phase. Here the gain medium is simply a single quantum dot, or a single atom, or a single molecule placed in the evanescent-wave region exterior to the microcavity, each of which is a perfectly quantum-mechanical element. A single atom, or a molecule or a quantum dot (712) is positioned within the evanescent-wave region (720) exterior to a silica microsphere (710), which can sustain ultra-high-Q WGM's (745) to produce the quantum field laser output (740) coupled out tangentially. The microsphere (710) approximately 50 to 500 microns in diameter can be made from an optical fiber (700) melted by a $CO_2$ laser or a hydrogen-oxygen flame. When the tip of an optical fiber (700) vertically held is heated by such an intense torch, the melted glass will form an ellipsoidal shape in which the horizontal cross-section is a circle while the vertical cross-section is an ellipse, due to the gravity in addition to surface tension. Thus the WGM's (745) in a microsphere so made are excited preferably along the horizontal equator and the laser output (740) is irradiated into the tangential directions as indicated in the figure. Most importantly, since the absorption coefficient of the fused silica is extremely small in the visible and infrared wavelength region, a microcavity that has the effective Q value as high as $10^9$-$10^{10}$ can be made. Since such an ultra-high-Q microcavity has extremely small loss, it is possible to generate a laser oscillation with only a very small gain such as the gain from a single atom, or a single molecule, or a single quantum dot. The laser output achieved in this type of configuration must be an entirely new type of light, which will carry every quantum properties arising from the interaction of a single atom (or a single molecule, etc.)—The perfect quantum mechanical object—and the microcavity. As a matter of great certainty, such a quantum field laser will serve as a fundamental and essential light source in the fields of quantum optics, near-field optics, and many others.

As described previously, the present invention realizes an ultra-high-Q microcavity laser based upon the evanescent-wave-coupled gain.

The semiconductor lasers having ultra-low threshold to be realized by present invention will minimize the energy consumption in the optical information's processing.

The technique of frequency tuning through the gain medium concentration control or the surface roughness control, originated by the present invention, will enhance the flexibility and applicability of the optical light source devices.

Also, since the present invention utilizes the microcavities of extremely small size, it can be applied to the manufacturing of a large-scale-integrated array of light source which will be essential in the optical information processing.

Furthermore, the quantum-field lasers described in the present invention will be the essential optical devices of light sources in the study of quantum optics, near-field optics, or in the related fields of engineering and technology.

While the present invention has been described in detail, it should be understood that various changes, substitutions and alterations can be made hereto without departing from the spirit and scope of the invention as defined by the appended claims.

**Claims**

1.  An evanescent-wave coupled microcavity laser, comprising:

    a microcavity having a circularly symmetric structure;
    a gain medium disposed outside said microcavity and having a refractive index lower than that of said microcavity; and
    energy applying means which applies an excitation energy to said gain medium to excite said gain medium,

    whereby said laser is oscillated from a gain obtained by a coupling of evanescent-waves of microcavity resonance modes.

2.  The evanescent-wave coupled microcavity laser of claim 1, wherein said microcavity is one selected from a group consisting of a cylinder type, a disk type, a sphere type and an ellipsoid type.

3.  The evanescent-wave coupled microcavity laser of claim 1, wherein said gain medium contains fluorescent molecules or fluorescent atoms.

4.  The evanescent-wave coupled microcavity laser of claim 3, wherein said energy applying means is an optical energy applying means with respect to said gain medium.

5.  The evanescent-wave coupled microcavity laser of claim 1, wherein said gain medium contains quantum dots.

6.  The evanescent-wave coupled microcavity laser of claim 5, wherein said energy applying means is a voltage applying means or an optical energy applying means with respect to said gain medium.

7.  The evanescent-wave coupled microcavity laser of claim 1, wherein said gain medium contains a semiconductor *p-n* junction or a semiconductor quantum well.

8.  The evanescent-wave coupled microcavity laser of claim 7, wherein said energy applying means is a current applying means with respect to said gain medium.

9.  The evanescent-wave coupled microcavity laser of claim 1, wherein said microcavity is formed by a silica melting process.

10. The evanescent-wave coupled microcavity laser of claim 1, wherein the circularly symmetric portion of said microcavity has a sectional diameter ranged from 10μm to 200μm.

11. The evanescent-wave coupled microcavity laser of claim 1, wherein said microcavity has a Q-value ranged from $10^9$ to $10^{10}$.

12. The evanescent-wave coupled microcavity laser of claim 1, wherein said microcavity irradiates light having an oscillation wavelength which is decided near a minimum value of a curve function $\gamma(\lambda)$,

$$\gamma(\lambda)=\frac{2\pi m/(\lambda n_t \eta Q)+\sigma_a(\lambda)}{\sigma_e(\lambda)+\sigma_a(\lambda)}$$

where, $\lambda$ is wavelength of light, $\eta$ is a volume ratio of the evanescent-wave to a volume of a WGM, $\sigma_a(\lambda)$ is an absorption sectional area of the gain medium at the wavelength of $\lambda$, $\sigma_e(\lambda)$ is an emission sectional area of the gain medium at the wavelength of $\lambda$, $n_t$ is numbers of the gain medium molecules, atoms or quantum dots per unit volume and m is a relative refractive index of the circularly symmetric microcavity to the gain medium.

13. The evanescent-wave coupled microcavity laser of claim 12, wherein an interface between said gain medium and its external region has a predetermined roughness.

14. The evanescent-wave coupled microcavity laser of claim 12, wherein said circularly symmetric microcavity has a predetermined surface roughness which is periodically controlled such that said circular microcavity acts as a grating, whereby said microcavity is oscillated with a single frequency.

15. The evanescent-wave coupled microcavity laser of claim 3, wherein a single atom, a single molecule or a quantum dot is positioned outside said microcavity to have a quantum property.

16. The evanescent-wave coupled microcavity laser of claim 5, wherein a single atom, a single molecule or a quantum dot is positioned outside said microcavity to have a quantum property.

17. The evanescent-wave coupled microcavity laser of claim 7, wherein a single atom, a single molecule or a quantum dot is positioned outside said microcavity to have a quantum property.

*FIG.1*

*FIG.2*

*FIG.3*

*FIG.4*

*FIG.5*

*FIG.6*

*FIG.7*